Europäisches Patentamt

European Patent Office

Office européen des brevets

(19)

(11) Numéro de publication: **0 061 377**
**B1**

(12) **FASCICULE DE BREVET EUROPEEN**

(45) Date de publication du fascicule du brevet:
**11.09.85**

(51) Int. Cl.⁴: **H 04 N 9/66,** H 03 D 5/00,
H 03 D 3/00, H 04 N 11/06

(21) Numéro de dépôt: **82400389.1**

(22) Date de dépôt: **05.03.82**

(54) Démodulateur numérique de signaux et récepteur ou système de télévision en couleurs comportant un tel démodulateur.

(30) Priorité: **17.03.81 FR 8105285**

(43) Date de publication de la demande:
**29.09.82 Bulletin 82/39**

(45) Mention de la délivrance du brevet:
**11.09.85 Bulletin 85/37**

(84) Etats contractants désignés:
**DE GB IT**

(56) Documents cités:
**FR - A - 1 585 253**
**FR - A - 2 065 682**
**FR - A - 2 433 756**
**US - A - 3 952 187**
**US - A - 4 090 145**

(73) Titulaire: **SOCIETE D'ELECTRONIQUE DE LA REGION
PAYS de LOIRE - SEREL, 74, rue du Surmelin,
F-75020 Paris (FR)**

(72) Inventeur: **Moraillon, Jean-Yves, THOMSON-CSF
SCPI 173, bld Haussmann, F-75360 Paris Cedex 08 (FR)**

(74) Mandataire: **Schmolka, Robert et al, THOMSON-CSF
SCPI 173, Bld Haussmann, F-75379 Paris Cedex 08 (FR)**

BUNDESDRUCKEREI BERLIN

## Description

La présente invention concerne les démodulateurs numériques permettant de démoduler d'une part, un signal modulé en fréquence, par exemple un signal de chrominance d'un signal vidéofréquence SECAM, et d'autre part un signal modulé en amplitude résultant d'une modulation en amplitude, à porteuse supprimée, de deux porteuses en quadrature de phase, par exemple un signal de chrominance d'un signal vidéofréquence PAL.

La présente invention concerne en outre des récepteurs et systèmes de télévision en couleurs comportant de tels dispositifs, en particulier des récepteurs et systèmes de télévision en couleurs PAL/SECAM. Par récepteur on comprendra ici tout appareil de visualisation sur l'écran d'un tube cathodique trichrome, d'une image en couleurs obtenue à partir d'un signal vidéofréquence ou vidéo composite comprenant une porteuse modulée en fréquence du système SECAM ou deux porteuses en quadrature de phase modulées en amplitude et transmis avec suppression de la fréquence porteuse en dehors des paliers arrière de synchronisation horizontale, du système PAL, tel qu'un moniteur ou un récepteur de télévision en couleurs.

Il est déjà connu un démodulateur numérique d'un signal modulé en fréquence du type SECAM, qui a été décrit dans la publication EP-P-0 029 376 (publiée le 27. 5. 81, après la date de priorité de la présente demande). Le principe de ce démodulateur connu consiste à échantillonner le signal à un rythme égal à 4 fois la fréquence centrale de la bande de fréquence du signal, puis à déterminer la position du vecteur tournant représentatif du signal dans un repère Oxy en effectuant un calcul d'arc tangente d'un rapport de deux échantillons successifs, et à déterminer la valeur de la variation de fréquence entre deux instants par comparaison de la position du vecteur tournant à ces instants.

Dans la suite du texte, un démodulateur d'un signal modulé en fréquence sera appelé: démodulateur SECAM.

Il est également connu un démodulateur numérique d'un signal modulé en amplitude résultant d'une modulation en amplitude, à porteuse supprimée, de deux porteuses en quadrature de phase, du type PAL, qui a été décrit dans la publication EP-A-0 037 317 (plubliée le 7. 10. 81 après la date de priorité de la présente demande). Dans la suite du texte, un démodulateur d'un signal résultant d'une telle modulation en amplitude sera appelé: démodulateur PAL.

Le principe mis en oeuvre par le démodulateur décrit dans la seconde publication précitée consiste à échantillonner le signal, à déterminer les coordonnées polaires du vecteur tournant représentatif du signal au moyen de deux échantillons successifs du signal à démoduler, et à calculer les valeurs des amplitudes des deux signaux de modulation en fonction des coordonnées polaires du vecteur tournant et des instants auxquels le signal à démoduler est échantillonné.

On connaît d'après le brevet US-A-4 090 145 un démodulateur numérique permettant la démodulation d'un signal modulé en fréquence en phase ou en amplitude et comportant essentiellement un convertisseur analogique-numérique, un dispositif à retard fournissant de signaux en quadrature, et des circuits de calcul de coordonnées polaires et de la variation de la fréquence du signal à demoduler.

Dans les systèmes de télévision PAL/SECAM, il est connu de réaliser un démodulateur numérique PAL/SECAM qui comporte un démodulateur PAL et un démodulateur SECAM tels que ceux cités dans l'art antérieur.

Une telle réalisation met en oeuvre un procédé de démodulation PAL et un procédé de démodulation SECAM tolalement indépendants.

La présente invention se rapporte à un démodulateur numérique PAL/SECAM bien plus simple que celui obtenu à l'aide des démodulateurs PAL et SECAM de l'art antérieur. Cette simplicité est due à une mise en oeuvre d'un procédé de démodulation SECAM et d'un procédé de démodulation PAL présentant des parties communes, ce qui entraîne une diminution du nombre de circuits nécessaires à la réalisation du démodulateur.

Selon l'invention, il est proposé un démodulateur numérique permettant la démodulation soit d'un signal $x_S(t)$ modulé en fréquence autour d'une fréquence F, soit d'un signal $x_P(t)$ modulé en amplitude résultant d'une modulation en amplitude, à porteuse supprimée, de deux porteuses à la même fréquence F et en quadrature de phase par deux signaux de modulation, ce démodulateur comportant un échantillonneur du signal à démoduler, un convertisseur analogique-numérique des échantillons sélectionnés par l'échantillonneur, un circuit à retard couplé à la sortie du convertisseur, un dispositif de détermination du module et de la phase du vecteur Z(t) représentatif du signal à démoduler et ayant des première et deuxième sorties délivrant respectivement le module et la phase du vecteur Z(t), et des premiers moyens de calcul déterminant la variation de la fréquence du signal $x_S(t)$ en fonction des variations de la phase du vecteur Z(t), caractérisé en ce que l'échantillonneur a une fréquence d'échantillonnage 4F, en ce que le circuit à retard comporte un premier dispositif à retard, de retard $\Theta_1$ égal à $\dfrac{1}{4F}$, ayant une entrée couplée à la sortie du convertisseur, et un deuxième dispositif à retard, de retard $\Theta_1$, ayant une entrée couplée à la sortie du premier dispositif à retard, en ce que le dispositif de détermination du module et de la phase du vecteur Z(t) comporte des première, deuxième et troisième entrées respectivement couplées à la sortie du convertisseur, à la sortie du premier dispositif à retard et à la sortie du deuxième dispositif à retard, et en ce que ce démodulateur comporte de deuxièmes moyens de calcul déterminant les amplitudes $\alpha$ et $\beta$ des deux signaux de modulation du signal $x_P(t)$ en fonction des valeurs du module et de la phase du vecteur $Z(t)$.

Selon l'invention, il est également prévu un récepteur et un système de télévision comportant un tel démodulateur.

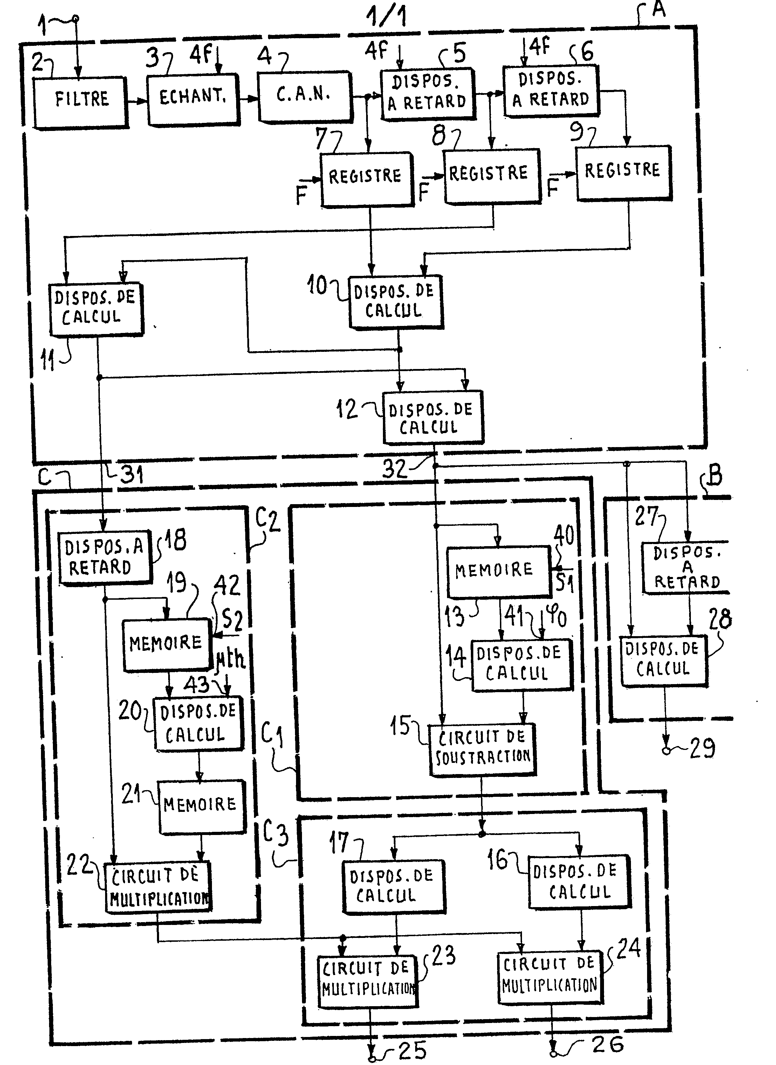

La présente invention sera mieux comprise et d'autres caractéristiques apparaîtront à l'aide de la description ci-après et de la figure unique s'y rapportant sur laquelle est représenté un mode de réalisation du démodulateur selon l'invention.

En vue de rendre le dessin plus clair et de simplifier l'exposé, les dispositifs de synchronisation précise, relevant de la technologie courante, n'ont pas été représentés.

L'exemple de réalisation décrit sur cette figure permet de démoduler soit un signal de chrominance d'un signal vidéofréquence SECAM, soit un signal de chrominance d'un signal vidéofréquence PAL.

Il est rappelé qu'un signal de chrominance SECAM est modulé en fréquence autour d'une sous-porteuse au voisinage de 4,3 MHz et présente un spectre de fréquences s'étendant de 3,9 MHz à 4,7 MHz, et qu'un signal de chrominance PAL résulte d'une modulation en amplitude de deux sous-porteuses de même fréquence égale à 4,4 MHz, mais déphasées l'une par rapport à l'autre de 90°.

Le démodulateur selon l'invention est constitué de trois parties distinctes A, B, et C, d'une borne d'entrée 1 destinée à recevoir soit un signal vidéofréquence PAL, soit un signal vidéofréquence SECAM, d'une borne de sortie 29 utilisée lors d'une démodulation d'un signal de chrominance SECAM, et de deux bornes de sortie 25 et 26 utilisées lors d'une démodulation d'un signal de chrominance PAL.

Les parties A et B constituent un démodulateur SECAM mettant en oeuvre un procédé de démodulation qui se différencie du procédé décrit dans l'art antérieur par la façon de déterminer la position du vecteur tournant (partie A).

Les parties A et C constituent un démodulateur PAL ayant une partie A commune avec le démodulateur SECAM. Ce démodulateur PAL met en oeuvre un procédé de démodulation qui se différencie du procédé décrit dans l'art antérieur par la façon de déterminer les coordonnées polaires du vecteur tournant (partie A).

L'originalité de ce démodulateur PAL/SECAM est d'utiliser d'une part un démodulateur SECAM (parties A et B) dans lequel la détermination de la position du vecteur tournant s'effectue à l'aide de combinaisons linéaires d'échantillons déterminées et judicieusement choisies, et d'autre part un démodulateur PAL (parties A et C) dans lequel la détermination des coordonnées polaires du vecteur tournant s'effectue à l'aide des mêmes combinaisons linéaires que celles utilisées par le démodulateur SECAM.

Pour pouvoir mieux comprendre le fonctionnement de ce démodulateur, il va être donné, à l'aide d'un développement théorique simple, les principales étapes du procédé de démodulation mis en oeuvre par le démodulateur SECAM (parties A et B), puis les principales étapes du procédé de démodulation mis en oeuvre par le démodulateur PAL (parties A et C).

1) Procédé de démodulation d'un signal de chrominance SECAM mis en oeuvre par les parties A et B:

La démodulation d'un signal de chrominance d'un signal vidéofréquence SECAM revient à déterminer la fréquence d'une sinusoïde variant dans une bande fréquence B de 0,8 MHz centrée autour de la fréquence F égale à 4,3 MHz. Il peut être considéré que l'obtention de cette sinusoïde est obtenue par la projection $x_S(t)$, sur un axe Ox d'un repère orthogonal Oxy, d'un vecteur tournant $Z_S(t)$ autour de l'origine O à la vitesse angulaire $2\pi(F + \delta F)$, $\delta F$ étant la valeur de l'excursion de fréquence et t représentant le temps. L'équation de $x_S(t)$ est donnée par:

$$x_S(t) = R \cos [2\pi (F + \delta F) t + \Psi_0] = R \cos \Theta (t)$$

Soient trois valeurs de $x_S(t)$ obtenues à des intervalles de temps réguliers égaux à $\dfrac{1}{4F}$, par exemple $x_S(t_1)$, $x_S\left(t_1 - \dfrac{1}{4F}\right)$ et $x_S\left(t_1 - \dfrac{2}{4F}\right)$, $t_1$ étant un instant quelconque.

Les expressions de ces trois échantillons sont les suivantes:

$$
\begin{cases}
x_S(t_1) = R \cos \Theta (t_1), \\[2mm]
x_S\left(t_1 - \dfrac{1}{4F}\right) = R \sin \left[\Theta(t_1) - \dfrac{\pi}{2} \quad \dfrac{\delta F}{F}, \right] \\[4mm]
x_S\left(t_1 - \dfrac{2}{4F}\right) = - R \cos \left[\Theta(t_1) - \pi \dfrac{\delta F}{F}, \right]
\end{cases}
$$

Soit $\Theta'(t_1) = \Theta(t_1) - \dfrac{\pi}{2} \dfrac{\delta F}{F}$, ce qui entraine:

3

$$\begin{cases} x_S(t_1) = R \cos\left[\Theta'(t_1) + \dfrac{\pi}{2}\ \dfrac{\delta F}{F}\right] \\[2mm] x_S\left(t_1 - \dfrac{1}{4F}\right) = R \sin \Theta'(t_1) \\[2mm] x_S\left(t_1 - \dfrac{2}{4F}\right) = -R \cos\left[\Theta'_1(t_1) - \dfrac{\pi}{2}\ \dfrac{\delta F}{F}\right] \end{cases}$$

d'où:

$$y_S(t_1) = \frac{x_S(t_1) - x_S\left(t_1 - \dfrac{2}{4F}\right)}{2} = R\ \cos\Theta'(t_1) \cdot \cos\ \frac{\pi}{2}\ \frac{\delta F}{F} \text{ et } R = \sqrt{x_S^2(t_1) + x_S^2\left(t_1 - \dfrac{1}{4F}\right)}$$

$$(1)$$

La bande relative du signal de chrominance étant petite devant 4,3 MHz (0,8 MHz par rapport à 4,3 MHz), il peut être considéré que $\dfrac{\delta F}{F} \ll 1$, ce qui entraine que $\cos \dfrac{\pi}{2}\ \dfrac{\delta F}{F}$ est égal à 1. Il en résulte qu'une estimation $\hat{\Theta}'(t_1)$ de l'angle $\Theta'(t_1)$ peut être calculée de la façon suivante:

$$\hat{\Theta}_S'(t_1) = \text{arc } \cos\left[\frac{y_S(t_1)}{\sqrt{y_S^2(t_1) + x_S^2\left(t_1 - \dfrac{1}{4F}\right)}}\right] \qquad (2)$$

Au bout d'une période $\dfrac{1}{F}$, le vecteur $Z_S(t)$ a tourné dans le repère Oxy de $2\pi\dfrac{\Delta F}{F}$ à $2\pi$ près. L'expression qui relie la variation d'angle $\Delta\hat{\Theta}'\left(t_1 + \dfrac{1}{F}\right)$ et la variation de fréquence $\Delta\hat{F}$ entre deux instants d'intervalle $\dfrac{1}{F}$ est la suivante:

$$\Delta\hat{\Theta}'\left(t_1 + \frac{1}{F}\right) = 2\pi\ \frac{\Delta\hat{F}}{F}, \text{ d'où } \Delta\hat{F} = \frac{F}{2\pi}\ \Delta\hat{\Theta}'\left(t_1 + \frac{1}{F}\right) \qquad (3)$$

avec

$$\Delta\hat{\Theta}\left(t_1 + \frac{1}{F}\right) = \hat{\Theta}'\left(t_1 + \frac{1}{F}\right) - \hat{\Theta}'(t_1) \qquad (4)$$

En pratique, pour mettre en oeuvre un tel procédé de calcul, il suffit d'échantillonner le signal de chrominance à un rythme égal à 4 fois la fréquence F, de stocker chaque échantillon pendant une durée $\dfrac{2}{4F}$ afin de disposer à chaque instant de trois échantillons successifs, et de calculer une estimation $\Delta\hat{\Theta}'(t_1)$ de la variation d'angle par la formule (4) après avoir calculé $\hat{\Theta}'(t_1)$ et $\hat{\Theta}'\left(t_1 + \dfrac{1}{F}\right)$ par la formule (2). Il est ensuite déduit une estimation $\Delta\hat{F}$ de la valeur de la variation de fréquence entre les instants $t_1$ e $t_1 + \dfrac{1}{F}$ par la formule (3).

Le procédé de calcul SECAM qui vient d'être explicité a pour intérêt de déterminer la position du vecteur tournant (c'est-à-dire $\hat{\Theta}'(t_1)$) à l'aide d'un arc cosinus plus simple à mettre en oeuvre que le calcul d'arc tangente de l'art antérieur. Un autre avantage de ce procédé de calcul est d'être utilisable lors d'une démodulation d'un signal de chrominance PAL.

En effet, il va être démontré que le procédé de démodulation mis en oeuvre par le démodulateur PAL cité dans l'art antérieur peut être appliqué en prenant comme coordonnées polaires du vecteur tournant R et $\hat{\Theta}'(t_1)$ calculé selon le procédé de calcul SECAM.

2) Procédé de démodulation d'un signal de chrominance PAL mis en oeuvre par les parties A et C:
L'expression algébrique de l'amplitude instantanée $x_P(t)$ d'un signal de chrominance d'un signal vidéofréquence PAL est la suivante:

$$x_P(t) = A(t) \cos\omega t + B(t) \sin\omega t \text{ avec } \omega = 2\pi F. \qquad (5)$$

Les termes $\cos\omega t$ et $\sin\omega t$ correspondent respectivement à la première sous-porteuse et à la seconde sous-porteuse de même pulsation et déphasées de 90° l'une par rapport à l'autre.

4

Les termes A(t) et B(t) correspondent aux signaux de modulation en amplitude des deux sous-porteuses.

Pendant une période égale à $\frac{1}{F}$, les variations des signaux de modulation sont suffisamment faible pour que l'on puisse considérer les termes A(t) et B(t) comme constants.

Sur une période de la sous-porteuse, il est donc supposé:

$$\begin{cases} A(t) = a, \\ B(t) = \beta, \text{ où} \end{cases}$$

$\alpha$ et $\beta$ correspondent à des constantes.

L'expression algébrique (5) devient alors:

$$x_P(t) = \sqrt{\alpha^2 + \beta^2} \cdot \cos\left(\omega t - \text{arc tg } \frac{\beta}{\alpha}\right). \tag{6}$$

La démodulation d'un signal dont l'amplitude est donnée par l'expression (6) revient à déterminer les valeurs de $\alpha$ et de $\beta$.

Considérons les valeurs $x_P(t_1)$, $x_P\left(t_1 - \frac{1}{4F}\right)$, et $x_P\left(t_1 - \frac{2}{4F}\right)$ de l'amplitude du signal de chrominance aux instants $t_1$, $t_1 - \frac{1}{4F}$, et $t_1 - \frac{2}{4F}$, $t_1$ étant un instant quelconque.

Les expressions de ces trois valeurs sont les suivantes:

$$x_P(t_1) = \sqrt{\alpha^2 + \beta^2} \cdot \cos\left(\omega t_1 - \text{arc tg } \frac{\beta}{\alpha}\right)$$

$$x_P\left(t_1 - \frac{1}{4F}\right) = \sqrt{\alpha^2 + \beta^2} \cdot \sin\left(\omega t_1 - \text{arc tg } \frac{\beta}{\alpha}\right)$$

$$x_P\left(t_1 - \frac{2}{4F}\right) = -\sqrt{\alpha^2 + \beta^2} \cdot \cos\left(\omega t_1 - \text{arc tg } \frac{\beta}{\alpha}\right)$$

Considérons le cercle trigonométrique classique d'axes orthogonaux OX et OY et le vecteur $Z_P(t)$ tourant autour de O et dont la projection sur l'axe OX est $x_P(t)$.

Les coordonnées polaires $(\rho t_1, \Theta t_1)$ du vecteur $Z_P(t_1)$ sont calculables à l'aide des formules suivantes:

$$\begin{cases} \rho t_1 = \sqrt{\alpha^2 + \beta^2} = \sqrt{y_P^2(t_1) + x_P^2\left(t_1 - \frac{1}{4F}\right)} \tag{7} \\ \\ \text{avec} \quad y_P(t_1) = \dfrac{x_P(t_1) - x_P\left(t_1 - \frac{2}{4F}\right)}{2}, \text{et} \\ \\ \Theta t_1 = \text{arc cos } \dfrac{y_P(t_1)}{\sqrt{y_P^2(t_1) + x_P^2\left(t_1 - \frac{1}{4F}\right)}} = \omega t_1 - \text{arc tg } \frac{\beta}{\alpha}. \tag{8} \end{cases}$$

Il est à noter qu'en remplaçant $x_P(t_1)$ par $x_S(t_1)$, les expressions (7) et (8) sont semblables aux formules (1) et (2) obtenues dans le cas d'une démodulation d'un signal de chrominance SECAM.

La formule (8) ne permet pas de déduire directement arc tg $\frac{\beta}{\alpha}$. En effet, le terme $\omega t_1$ dépend de l'instant initial d'échantillonnage.

L'élimination de ce terme s'effectue simplement en utilisant l'expression algébrique de l'angle polaire du vecteur $\vec{OS}_t$ associé au signal de chrominance couleur, dit encore salve de référence. Cette salve de référence est constituée d'un train de signaux sinusoïdaux à la fréquence exactre F de la sous-porteuse de chrominance et d'amplitude constante. L'expression algébrique de l'amplitude instantanée de la salve de référence est la suivante:

$$S(t) = C \cos(\omega t + \varphi_0)$$

Dans cette expression, C représente une constante, $\varphi_0$ correspond au déphasage entre la salve de référence et la première sous-porteuse. La valeur de $\varphi_0$ est de 135°.

Soient $(\mu, \Psi)$ les coordonnées polaires du vecteur $Z_t(t)$ en appliquant le même procédé de calcul que celui décrit précédemment pour l'expression de l'amplitude instantanée du signal de chrominance $x_P(t)$,

il peut être déduit les formules suivantes:

$$\begin{cases} \mu = \sqrt{y_b^2(t_1) + S^2\left(t - \dfrac{1}{4F}\right)} = C, & (9) \\[3em] \psi = \arccos \dfrac{S(t_1) - S\left(t_1 - \dfrac{2}{4F}\right)}{2\sqrt{y_b^2(t_1) + S^2\left(t_1 - \dfrac{1}{4F}\right)}} = \omega t_1 + \varphi_0, & (10) \end{cases}$$

avec

$$y\,b(t_1) = \frac{S(t_1) - S\left(t_1 - \dfrac{2}{4F}\right)}{2}.$$

En combinant 8 et 10, le terme $\omega t_1$ peut être éliminé:

$$\text{arc tg}\ \frac{\beta}{\alpha} = \Psi - \Theta t_1 - \varphi_0 = \gamma. \tag{11}$$

Les valeurs de $\alpha$ et de $\beta$ sont alors données par les expressions suivantes:

$$\begin{cases} \alpha = \rho t_1 \ \cos \gamma, & (12) \\ \beta = \rho t_1 \ \sin \gamma. & (13) \end{cases}$$

En pratique, le procédé de démodulation qui vient d'être décrit consiste à échantillonner d'une part la salve de référence et d'autre part le signal de chrominance à un rythme égal à 4 fois la fréquence F de la sous-porteuse, à stocker chaque échantillon pendant une durée $\dfrac{2}{4F}$ afin de disposer à chaque instant de trois échantillons successifs, à calculer les coordonnées polaires des vecteurs associés à la salve de référence et au signal de chrominance (formules (7), (8), (9) et (10)), à déterminer la valeur de $\gamma$ d'après la formule (11), et enfin de calculer les valeurs de $\alpha$ et de $\beta$ d'après les équations (12) et (13).

Les procédés de démodulation SECAM et PAL qui viennent d'être exposés comportent une partie commune. Il peut en effet être constaté que les formules (1) et (2) donnant les coordonnées polaires $R_S$ et $\hat{\Theta}_S'(t_1)$ du vecteur $Z_S(t)$ sont identiques aux formules (7) et (8) donnant les coordonnées polaires $\rho t_1$ et $\Theta t_1$ du vecteur $Z_P(t)$ et aux formules (9) et (10) donnant les coordonnées polaires $\mu$ et $\Psi$ du vecteur $Z_r(t)$.

Ainsi, le procédé de calcul des coordonnées polaires des vecteurs $Z_S(t)$, $Z_P(t)$ et $Z_r(t)$ est le même, sa mise en oeuvre peut donc être faite par les mêmes circuits.

Le fonctionnement du démodulateur PAL/SECAM décrit sur la figure est le suivant:

La partie A du démodulateur correspond aux circuits mettant en oeuvre le procédé de calcul commun aux deux procédés de démodulation décrits précédemment. Cette partie A comporte une entrée reliée à la borne d'entrée 1, une première sortie 31 fournissant soit R, soit $\rho_{t_1}$, soit $\mu$, et une deuxième sortie 32 fournissant soit $\hat{\Theta}'(t_1)$, soit $\Theta_{t_1}$, soit $\Psi$ selon le type de signal présent sur la borne d'entrée 1.

Le signal vidéofréquence reçu sur la borne d'entrée 1 est filtré par un filtre 2 pour sélectionner uniquement le signal de chrominance. Ce filtre est un passe-bande. Le signal obtenu à la sortie du filtre 2 est échantillonné, à partir d'un instant initial $t_0$, par un échantillonner 3 suivant la fréquence d'échantillonnage 4F. Les échantillons sont ensuite convertis en signaux binaires par un convertisseur analogique-numérique 4.

Un dispositif à retard 5 retarde les échantillons fournis par le concertisseur 4 d'une durée $\tau = \dfrac{1}{4F}$. Un autre dispositif à retard 6 retarde les échantillons fournis par le dispositif à retard 5 d'une durée $\tau$. Un registre 7 dont l'entrée est reliée à la sortie du convertisseur 4, un registre 8 dont l'entrée est connectée à la sortie du dispositif à retard 5 et un registre 9 dont l'entrée est reliée à la sortie du dispositif à retard 6 sont actionnés à la fréquence F et permettent, à un instant $t_1$ quelconque, de disposer simultanément de trois échantillons successifs:

$$X(t_1),\ X\left(t_1 - \frac{1}{4F}\right) \text{ et } X\left(t_1 - \frac{2}{4F}\right).$$

Un dispositif de calcul 10, dont une première et une deuxième entrée sont respectivement reliées à la

6

sortie du registre 7 et à la sortie du registre 9, permet de calculer

$$Y(t_1) = \frac{X(t_1) - X\left(t_1 - \frac{2}{4F}\right)}{2}.$$

Un dispositif de calcul 11 dont une première et une deuxième entrée sont respectivement connectées à la sortie du registre 8 et à la sortie du dispositif de calcul 10 permet de calculer

$$\left|\sqrt{Y^2(t_1) + X^2\left(t_1 - \frac{1}{4F}\right)}\right|.$$

Un autre dispositif de calcul dont une première et une deuxième entrée sont respectivement reliées à la sortie du dispositif de calcul 10 et à la sortie du dispositif de calcul 11, permet de calculer arc cos

$$\left[\frac{Y(t_1)}{\left|\sqrt{Y^2(t_1) + X^2\left(t_1 - \frac{1}{4F}\right)}\right|}\right].$$

Ainsi, dans le cas d'un signal de chrominance SECAM, les dispositifs de calcul 11 et 12 fournissent respectivement R (formule (1)) et $\Theta'(t_1)$ (formule (2)). Dans le cas d'un signal de chrominance PAL, les dispositifs de calcul 11 et 12 fournissent respectivement $\rho_{t_1}$ (formule (7)) et $\Theta_{t_1}$ (formule (8)). Dans le cas de la salve de référence, ces dispositifs de calcul 11 et 12 fournissant respectivement $\mu$ et $\Psi$ (formules (9) et (10)).

La partie B du démodulateur selon l'invention est constitué d'un dispositif à retard 27 dont l'entrée est reliée à la sortie du dispositif de calcul 12 et d'un dispositif de calcul 28 dont une première et une deuxième entrées sont respectivement reliées à la sortie du dispositif de calcul 12 et à la sortie du dispositif à retard 27 et dont la sortie est connectée à la borne de sortie 29. Le retard engendré par le dispositif à retard 27 est $\frac{1}{F}$. Le dispositif de calcul 28 permet de calculer selon la formule (3) la variation de fréquence $\Delta\hat{F}$ entre deux instants distants de $\frac{1}{F}$.

La partie B du démodulateur n'est utilisable que pour la démodulation d'un signal de chrominance SECAM.

Pour démoduler un signal de chrominance PAL, c'est la partie C du démodulateur qui est utilisée. Cette partie C met en oeuvre le procédé de calcul explicité précédemment à partir des valeurs $\rho_{t_1}$, $\Theta_{t_1}$, $\mu$ et $\Psi$ générées par les dispositifs de calcul 11 et 12.

Cette partie C comporte trois sous-parties $C_1$, $C_2$ et $C_3$.

La sous-partie $C_1$ permet de calculer arc tg $\frac{\beta}{\alpha}$ selon la formule (11). Pour cela, cette sous-partie $C_1$ comporte une mémoire 13 ayant une entrée principale reliée à la sortie du dispositif de calcul 12, un dispositif de calcul 14 dont l'entrée principale est connectée à la sortie de la mémoire 13 et un circuit de soustraction 15 dont une première et une deuxième entrée sont respectivement connectées à la sortie du dispositif de calcul 12 et à la sortie du dispositif de calcul 14.

La mémoire 13 reçoit sur une entrée auxiliaire 40 un signal de commande de mémorisation $S_1$ indiquant la présence de la salve de référence. Cette mémoire 13 mémorise donc la valeur de $\Psi$ associée à la salve de référence. A la fin de la salve de référence, la mémoire 13 fournit la valeur de $\Psi$ au dispositif de calcul 14. Ce dispositif de calcul 14 reçoit sur une autre entrée auxiliaire 41 la valeur de $\varphi_0$ et calcule $\Psi - \varphi_0$. Le dispositif de calcul 15 calcule $\Psi - \Theta_{t_1} - \varphi_0$, c'est-à-dire $y$ (formule (11)).

La sous-partie $C_2$ permet de calculer la valeur réelle de $\rho_{t_1}$.

En effet, la valeur fournie par le dispositif de calcul 11 est en fait $\rho \frac{t_1}{\alpha}$, $\alpha$ étant un coefficient variable dans le temps, dépendant de la source vidéofréquence et de la voie de transmission. Pour cela, la sous-partie $C_2$ comporte un dispositif à retard 18, deux mémoires 19 et 21, un circuit de soustraction 20 et un circuit de multiplication 22.

Le principe de calcul mis en oeuvre par cette sous-partie $C_2$ consiste à comparer la valeur du module $\mu$ calculé lors de la présence de la salve de référence à la valeur théorique de ce module. De cette comparaison, il peut être déduit le coefficient $\alpha$. Ce coefficient $\alpha$ est ensuite utilisé pour corriger les valeurs du module $\rho_{t_1}$ associé au signal de chrominance PAL.

Le dispositif à retard 18 dont l'entrée est reliée à la sortie du dispositif de calcul 11 engendre un retard qui correspond à la différence de la durée nécessaire au calcul du module et celle nécessaire au calcul de la phase. La mémoire 19 dont l'entrée principale est connectée à la sortie du dispositif à retard 18 reçoit sur une entrée auxiliaire 42 un signal de commande de mémorisation $S_2$ indiquant la présence de la salve de référence. Cette mémoire 19 mémorise donc la valeur $\mu$ du module associé à la salve de référence. Le circuit de soustraction 20 comporte une première entrée reliée à la sortie de la mémoire 19 et une deuxième entrée 43 recevant la valeur théorique $\mu_{th}$ du module associé` la salve de référence. Le circuit de soustraction 20 calcule la différence entre $\mu$ et $\mu_{th}$. La mémoire 21, dont l'entrée est reliée est reliée à la sortie du circuit de soustraction 20, fournit la valeur du coefficient $\alpha$ correspondant à la différence entre $\mu_{th}$ et $\mu$. Le circuit de multiplication 22 dont une première et une deuxième entrée sont respectivement connectées à la sortie du dispositif à retard et à la sortie de la mémoire 21, effectue une multiplication des valeurs du module associées au signal de chrominance par le coefficient $\alpha$ fourni par la mémoire 21 et délivre les valeurs corrigées de $\rho_{t_1}$.

La sous-partie $C_3$ comporte deux dispositifs de calcul 16 et 17 et deux circuits de multiplication 23 et 24, et permet de calculer $\alpha$ et $\beta$ d'après les formules (12) et (13). L'entrée du dispositif de calcul 17 et l'entrée du dispositif de calcul 16 sont connectées à la sortie du circuit de soustraction 15 qui délivre la valeur $y$. Le dispositif de calcul 16 calcule sin $y$. Une première entrée du circuit de multiplication 23 et une première entrée du circuit de multiplication 24 sont reliées à la sortie du circuit de multiplication 22 qui délivre les valeurs corrigées $\rho_{t_1}$. La deuxième entrée du circuit de multiplication 23 est reliée à la sortie du dispositif de calcul 17. La deuxième entrée du circuit de multiplication 24 est connectée à la sortie du dispositif de calcul 16. Les circuits de multiplication 23 et 24 calculent respectivement $\alpha$ et $\beta$ selon les formules (12) et (13) et délivrent ces valeurs sur les bornes de sortie 25 et 26.

L'invention n'est pas limitée au mode de réalisation décrit et représenté, de nombreuses variantes de réalisation sont possibles.

En particulier, les fonctions effectuées par les dispositifs à retard, les registres et les circuits de calcul qui ont été décrits peuvent être effectuées à l'aide de dispositifs à transfert de charge (appelés D. T. C), le convertisseur analogique-numérique 4 étant alors supprimé.

Il est à noter que l'invention n'est pas seulement applicable pour démoduler un signal de chrominance PAL ou SECAM, mais peut être utilisée pour démoduler tout signal modulé en fréquence et tout signal résultant d'une modulation en amplitude, à porteuse supprimée, de deux porteuses à la même fréquence F et en quadrature de phase (tel que les signals de chrominance du système NTSC, par exemple).

## Revendications

1. Démodulateur numérique permettant la démodulation soit d'un signal $x_S(t)$ modulé en fréquence autour d'une fréquence F, soit d'un signal $x_P(t)$ modulé en amplitude résultant d'une modulation en amplitude à porteuse supprimée de deux porteuses à la même fréquence F et en quadrature de phase par deux signaux de modulation, ce démodulateur comportant un échantillonneur (3) du signal à démoduleur, un convertisseur analogique-numérique (4) des échantillons sélectionnés par l'échantillonneur, un circuit à retard (5, 6) couplé à la sortie du convertisseur (4), un dispositif de détermination (10, 11, 12) du module et de la phase du vecteur Z(t) représentatif du signal à démoduler et ayant des première (31) et deuxième (32) sorties délivrant respectivement le module et la phase du vecteur Z(t), et des premiers moyens de calcul (B) déterminant la variation de la fréquence du signal $x_S(t)$ en fonction des variations de la phase du vecteur Z(t), caractérisé en ce que l'échantillonneur a une fréquence d'échantillonnage 4F, en ce que le circuit à retard comporte un premier dispositif à retard (5), de retard $\Theta_1$ égal à $\dfrac{1}{4F}$, ayant une entrée couplée à la sortie du convertisseur (4), et un deuxième dispositif à retard (6), de retard $\Theta_1$, ayant une entrée couplée à la sortie du premier dispositif à retard, en ce que le dispositif de détermination du module et de la phase du vecteur Z(t) comporte des première, deuxième et troisième entrées respectivement couplées à la sortie du convertisseur (4), à la sortie du premier dispositif à retard (5) et à la sortie du deuxième dispositif à retard, et en ce que ce démodulateur comporte des deuxièmes moyens de calcul (C) déterminant les amplitudes $\alpha$ et $\beta$ des deux signaux de modulation du signal $x_P(t)$ en fonction des valeurs du module et de la phase du vecteur Z(t).

2. Démodulateur selon la revendication 1 dans lequel le convertisseur (4), le premier dispositif à retard (5) et le deuxième dispositif à retard (6) fournissent respectivement à un instant $t_1$ quelconque les échantillons $X(t_1)$, $X\left(t_1 - \dfrac{1}{4F}\right)$ et $X\left(t_1 - \dfrac{2}{4F}\right)$, caractérisé en ce que le dispositif de détermination (10, 11 et 12) du module et de la phase du vecteur Z(t) représentatif du signal à démoduler comporte: un dispositif de calcul (10) calculant

$$Y(t_1) = \frac{X(t_1) - X\left(t_1 - \dfrac{2}{4F}\right)}{2} ;$$

un deuxième dispositif de calcul (11) calculant de module $\rho(t_1)$ selon la formule:

$$\rho\,(t_1) = \left|\sqrt{Y^2(t_1) + X^2\left(t_1 - \frac{1}{4F}\right)}\right|;$$

un troisième dispositif de calcul (12) calculant la phase $\Theta(t_1)$ selon la formule:

$$\Theta(t_1) = \text{arc cos}\left[\frac{Y(t_1)}{\left|\sqrt{Y^2(t_1) + X^2\left(t_1 - \frac{1}{4F}\right)}\right|}\right]$$

3. Démodulateur selon la revendication 1, caractérisé en ce que la deuxième sortie (32) du dispositif de détermination (10, 11 et 12) du module et de la phase du vecteur Z(t) fournit à un instant quelconque $t_1$ la valeur $\Theta(t_1)$, et en ce que les premiers moyens de calcul (B) comportent un troisième dispositif à retard (27), de retard $\Theta_2$ égal à $\frac{1}{F}$, ayant une entrée couplée à la deuxième sortie (32) du dispositif de détermination (10, 11 et 12) et une sortie fournissant à chaque instant $t_1$ la valeur $\Theta\left(t_1 - \frac{1}{F}\right)$, et un dispositif de calcul calculant la valeur $\Delta\hat{F}_{t_1}$ de la variation de fréquence entre les instants $t_1 - \frac{1}{F}$ et $t_1$ selon la formule:

$$\Delta\hat{F}_{t_1} = \frac{F}{2\pi}\,\Theta\left((t_1) - \Theta\left(t_1 - \frac{1}{F}\right)\right)$$

4. Démodulateur selon la revendication 1, caractérisé en ce que les deuxièmes moyens de calcul (C) comportent un premier ensemble de calcul ($C_1$) calculant arc tg$\frac{\beta}{\alpha}$ en fonction de l'amplitude du vecteur Z(t) et de l'instant initial d'échantillonnage; et un deuxième ensemble de calcul ($C_3$) calculant $\alpha$ et $\beta$ selon les formules suivantes:

$$\alpha = \rho\,(t)\,\cos\left[\text{arc tg }\frac{\beta}{\alpha}\right]\text{ et }\beta = \rho\,(t)\,\sin\left[\text{arc tg }\frac{\beta}{\alpha}\right],$$

$\rho\,(t)$ correspondant à la valeur du module du vecteur Z(t).

5. Démodulateur selon la revendication 4, le signal modulé en amplitude étant précédé par un signal de référence à la fréquence F et d'amplitude donnée, caractérisé en ce que le premier ensemble de calcul ($C_1$) comporte une mémoire (40) mémorisant la valeur $\Psi$ de la phase du vecteur représentatif du signal de référence; un premier dispositif de calcul (41) calculant $\Psi - \varphi_0$, $\varphi_0$ correspondant au déphasage du signal de référence avec l'une des porteuses; un deuxième dispositif de calcul (15) calculant arc tg$\frac{\beta}{\alpha}$ selon la formule suivante:

$$\text{arc tg }\frac{\beta}{\alpha} = (\Psi - \varphi_0) - \Theta\,(t),$$

$\Theta\,(t)$ correspondant à la valeur de la phase du vecteur Z(t).

6. Démodulateur selon la revendication 4, le signal modulé en amplitude étant précédé par un signal de référence à la fréquence F et d'amplitude donnée, lesdits signaux ayant subi une atténuation dont le coefficient est $\alpha$, caractérisé en ce que les deuxièmes moyens de calcul (C) comportent: un troisième ensemble de calcul ($C_2$) constitué d'une première mémoire (42) mémorisant la valeur du module du vecteur associé au signal de référence; un premier dispositif de calcul (43) calculant la différence entre $\mu$ et la valeur théorique $\mu_{th}$ de $\mu$; une deuxième mémoire (21) délivrant le coefficient d'atténuation $\alpha$ en fonction de cette différence; et un circuit de multiplication (22) multipliant les valeurs du module du vecteur associé au signal à démoduler par le coefficient $\alpha$ et délivrant ainsi les valeurs corrigées du module du vecteur associé au signal à démoduler.

7. Application d'un démodulateur PAL/SECAM selon l'une des revendications 1 à 6, à un récepteur ou moniteur de télévision en couleurs ou à un système de télévision en couleurs dans lequel une onde modulée par un signal vidéo composite du système PAL ou SECAM est démodulée afin d'en extraire, outre le signal de luminance, deux signaux de chrominance.

**Patentansprüche**

1. Digitaler Demodulator, mit einem entweder ein um eine Frequenz F herum frequenzmoduliertes

Signal $x_S(t)$ oder ein amplitudenmoduliertes Signal $x_P(t)$ demoduliert werden kann, das durch Amplitudenmodulation zweier in Phasenquadratur liegender Träger gleicher Frequenz mit zwei Modulationssignalen und anschließende Trägerunterdrückung gebildet wurde, wobei der Demodulator einen Tastschaltkreis (3) für das zu demodulierende Signal, einen Analog-Digital-Wandler (4) für die vom Tastschaltkreis ausgewählten Proben, einen Verzögerungsschaltkreis (5, 6), der an den Ausgang des Wandlers (4) angeschlossen ist, eine Vorrichtung (10, 11, 12) zur Bestimmung des Moduls und der Phase des für das zu demodulierende Signal repräsentativen Vektors $Z(t)$ mit einem ersten (31) und einem zweiten Ausgang (32), die den Modul bzw. die Phase des Vektors $Z(t)$ liefern, und erste Rechenmittel (B) aufweist, die die Variation der Frequenz des Signals $x_S(t)$ abhängig von den Variationen der Phase des Vektors $Z(t)$ bestimmen, dadurch gekennzeichnet, daß der Tastschaltkreis eine Tastfrequenz 4F besitzt, daß der Verzögerungsschaltkreis ein erstes Verzögerungsglied (5) mit einer Verzögerung $\Theta_1 = 1/4F$, dessen Eingang an den Ausgang des Wandlers (4) gekoppelt ist, und ein zweites Verzögerungsglied (6) mit einer Verzögerung $\Theta_1$ aufweist, dessen Eingang an den Ausgang des ersten Verzögerungsgliedes gekoppelt ist, daß die Vorrichtung zur Bestimmung des Moduls und der Phase des Vektors $Z(t)$ einen ersten, zweiten und dritten Eingang besitzt, die an den Ausgang des Wandlers (4) bzw. an den Ausgang des ersten Verzögerungsgliedes (5) bzw. an den Ausgang des zweiten Verzögerungsgliedes angeschlossen sind, und daß dieser Demodulator zweite Rechenmittel (C) aufweist, die die Amplituden $\alpha$ und $\beta$ der beiden Modulationssignale des Signals $x_P(t)$ abhängig von den Werten des Moduls und der Phase des Vektors $Z(t)$ bestimmen.

2. Demodulator nach Anspruch 1, in dem der Wandler (4), das erste und das zweite Verzögerungsglied (5, 6) zu einem beliebigen Zeitpunkt $t_1$ die Tastproben $X(t_1)$, $X(t_1 - 1/4F)$ bzw. $X(t_1 - 2/4F)$ liefern, dadurch gekennzeichnet, daß die Vorrichtung (10, 11 und 12) zur Bestimmung des Moduls und der Phase des für das zu demodulierende Signal repräsentativen Vektors $Z(t)$ eine Rechenvorrichtung (10) zur Berechnung von

$$Y(t_1) = \frac{X(t_1) - X\left(t_1 - \dfrac{2}{4F}\right)}{2},$$

eine zweite Rechenvorrichtung (11) zur Berechnung des Moduls $\rho(t_1)$ gemäß der Formel

$$\rho(t_1) = \left| \sqrt{Y^2(t_1) + X^2\left(t_1 - \frac{1}{4F}\right)} \right.$$

sowie eine dritte Rechenvorrichtung (12) enthält, in der die Phase $\Theta(t_1)$ gemäß der Formel berechnet wird:

$$\Theta(t_1) \, 3 \, \text{arc cos} \left[ \frac{Y(t_1)}{\left| \sqrt{Y^2(t_1) + X^2\left(t_1 - \frac{1}{4F}\right)} \right.} \right]$$

3. Demodulator nach Anspruch 1, dadurch gekennzeichnet, daß der zweite Ausgang (32) der Vorrichtung (10, 11 und 12) zur Bestimmung des Moduls und der Phase des Vektors $Z(t)$ zu einem beliebigen Zeitpunkt $t_1$ den Wert $\Theta(t_1)$ liefert und daß die ersten Rechenmittel (B) ein drittes Verzögerungsglied (27) mit einer Verzögerungszeit $\Theta_2 = 1/F$ und mit einem Eingang, der an den zweiten Ausgang (32) der Vorrichtung (10, 11 und 12) zur Bestimmung von Modul und Phase gekoppelt ist, und mit einem Ausgang, der zu jedem Zeitpunkt $t_1$ den Wert $\Theta(t_1 - 1/F)$ liefert, und eine Rechenvorrichtung aufweisen, die den Wert $\Delta \hat{F}_{t_1}$ für die Änderung der Frequenz zwischen den Zeitpunkten $t_1 - 1/F$ und $t_1$ gemäß folgender Formel berechnet:

$$\Delta \hat{F}_{t_1} = \frac{F}{2\pi} \Theta \left( (t_1) - \Theta\left(t_1 - \frac{1}{F}\right)\right)$$

4. Demodulator nach Anspruch 1, dadurch gekennzeichnet, daß die zweiten Rechenmittel (C) einen ersten Rechenblock ($C_1$) der den arc tg $(\beta/\alpha)$ abhängig von der Amplitude des Vektors $Z(t)$ und vom ursprünglichen Tastzeitpunkt berechnet, und einen zweiten Rechenblock ($C_3$) aufweisen, der $\alpha$ und $\beta$ gemäß folgenden Formeln berechnet:

$$\alpha = \rho(t) \cos \left[ \text{arc tg } \frac{\beta}{\alpha} \right]$$

und

$$\beta = \rho(t) \sin \left[ \text{arc tg } \frac{\beta}{\alpha} \right],$$

wobei $\rho$(t) dem Wert des Moduls des Vektors Z(t) entspricht.

5. Demodulator nach Anspruch 4, bei dem dem amplitudenmodulierten Signal ein Bezugssignal der Frequenz F und einer gegebenen Amplitude vorausgeht, dadurch gekennzeichnet, daß der erste Rechenblock ($C_1$) einen Speicher (40), der den Wert $\Psi$ der Phase des für das Bezugssignal repräsentativen Vektors speichert, eine erste Rechenvorrichtung (41), die $\Psi - \varphi_0$ berechnet, wobei $\varphi_0$ der Phasenverschiebung des Bezugssignals zu den Trägern entspricht, und eine zweite Rechenvorrichtung (15) aufweist, die arc tg $(\beta/\alpha)$ nach folgender Formel berechnet:

$$\text{arc tg } (\beta/\alpha) = (\Psi - \varphi_0) - \Theta(\text{t}),$$

wobei $\Theta$(t) dem Wert der Phase des Vektors Z(t) entspricht.

6. Demodulator nach Anspruch 4, bei dem dem amplitudenmodulierten Signal ein Bezugssignal mit der Frequenz F und gegebener Amplitude vorausgeht und diese Signale eine Dämpfung mit dem Koeffizienten $\alpha$ unterworfen worden sind, dadurch gekennzeichnet, daß die zweiten Rechenmittel (C) einen dritten Rechenblock ($C_2$) bestehend aus einem ersten Speicher (42) zur Speicherung des Werts des Moduls des dem Bezugssignal zugeordneten Vektors, eine erste Rechenvorrichtung (43) zur Berechnung der Differenz zwischen $\mu$ und dem theoretischen Wert $\mu_{th}$ von $\mu$, einen zweiten Speicher (21), der den Dämpfungskoeffizienten $\alpha$ abhängig von dieser Differenz liefert, und einen Multiplikationsschaltkreis (22) aufweisen, der die Werte des Moduls des dem zu demodulierenden Signal zugeordneten Vektors mit dem Koeffizienten $\alpha$ multipliziert und die korrigierten Werte des Moduls des dem zu demodulierenden Signal zugeordneten Vektors liefert.

7. Anwendung eines PAL/SECAM Demodulators nach einem der Ansprüche 1 bis 6 auf einen Farbfernsehempfänger oder -monitor oder auf ein Farbfernsehsystem, in dem eine durch ein zusammengesetztes Videosignal des PAL- oder SECAM-Systems modulierte Welle demoduliert wird, um daraus neben dem Signal für die Helligkeit zwei Farbwertsignale zu entnehmen.

## Claims

1. A digital demodulator for demodulating a signal $x_S$(t) which is frequency modulated around a frequency F, or a signal $x_P$(t) which is modulated in amplitude and which results from an amplitude modulation of two carriers of identical frequency F and of phase quadrature by two modulation signals, followed by a carrier suppression, this demodulator comprising a sampler (3) applied to the signal which is to be demodulated, an analog-digital-converter (4) to which the samples selected by the sampler are applied, a delay circuit (5, 6) coupled to the output of the converter (4), a device (10, 11, 12) for determining the module and the phase of the vector Z(t) which is representative for the signal to be demodulated, this device having first (31) and second outputs (32) furnishing respectively the module and the phase of the vector Z(t), and first computer means (B) fo determining the frequency variation of the signal $x_S$(t) as a function of the phase variations of the vector Z(t), characterized in that the sampler has a sampling frequency of 4 F, that the delay circuit comprises a first delay member (5) having a delay $\Theta_1$ equal to 1/4 F, and having an input which is coupled to the output of the converter (4), and a second delay member (6) of a delay $\Theta_1$, having an input which is coupled to the output of the first delay member, that the device for determining the module and the phase of the vector Z(t) comprises first, second and third inputs, which are coupled respectively to the output of the converter (4), to the output of the first delay member (5) and to the output of the second delay member, and that the demodulator comprises second computer means (C) for determining the amplitudes $\alpha$ and $\beta$ of the two modulation signals of the signal $x_P$(t) as a function of the values of the module and of the phase of the vector Z(t).

2. A demodulator according to claim 1, wherein the converter (4), the first delay member (5) and the second delay member (6) deliver at a given instant $t_1$ the samples $X(t_1)$, $X(t_1 - 1/4F)$ and $X(t_1 - 2/4F)$ respectively, characterized in that the device (10, 11 and 12) for determining the module and the phase of the vector Z(t) which is representative for the signal to be demodulated comprises: a computer device (10) which computes

$$Y(t_1) = \frac{X(t_1) - X\left(t_1 - \frac{2}{4F}\right)}{2},$$

a second computer device (11) computing the module $\rho(t_1)$ according to the formula:

$$\rho(t_1) = \left| \sqrt{Y^2(t_1) + X^2\left(t_1 - \frac{1}{4F}\right)}, \right.$$

a third computer device (12), computing the phase $\Theta(t_1)$ according to the formula:

$$\Theta(t_1) \; 3 \; \text{arc} \; \cos \left[ \frac{Y(t_1)}{\sqrt{Y^2(t_1) + X^2\left(t_1 - \frac{1}{4F}\right)}} \right]$$

3. A demodulator according to claim 1, characterized in that the second output (32) of the device (10, 11 and 12) for determining the module and the phase of the vector Z(t) delivers at a given instant $t_1$ the value $\Theta(_1)$, and that the first computer means (B) comprise a third delay member (27) having a delay $\Theta_2$ equal to 1/F and having an input which is coupled to the second output (32) of the device (10, 11 and 12) for determining the module and the phase, and an output delivering at each instant $t_1$ the value $\Theta(t_1 - 1/F)$, and a computer device calculating the value $\Delta \hat{F}_{t_1}$ of the frequency variation between the instants $t_1 - 1/F$ and $t_1$ according to the formula:

$$\Delta \hat{F}_{t_1} = \frac{F}{2\pi} \Theta\left((t_1) - \Theta\left(t_1 - \frac{1}{F}\right)\right)$$

4. A demodulator according to claim 1, characterized in that the second computer means comprise a first computer block ($C_1$) calculating arc tg ($\beta/\alpha$) as a function of the amplitude of the vector Z(t) and of the initial sampling instant, and a second computer block ($C_3$) calculating $\alpha$ and $\beta$ according to the following formulas

$$\alpha = \rho(t) \; \cos\left[ \text{arc tg} \; \frac{\beta}{\alpha} \right]$$

and

$$\beta = \rho(t) \; \sin\left[ \text{arc tg} \; \frac{\beta}{\alpha} \right],$$

in which $\rho(t)$ corresponds to the value of the module of the vector Z(t).

5. A demodulator according to claim 4, in which the signal modulated in amplitude is preceded by a reference signal at the frequency F and of a given amplitude, characterized in that the first computer block ($C_1$) includes a memory (40) for storing the value $\Psi$ of the phase of the vector representative for the reference signal, a first computer device (41) calculating $\Psi - \rho_0$, in which $\rho_0$ corresponds to the phase shift of the reference signal with respect to one of the carriers, a second computer device (15) calculating arc tg $\beta/\alpha$ according to the following formula:

$$\text{arc tg} \; (\beta/\alpha) = (\Psi - \varphi_0) - \Theta(t),$$

in which $\Theta(t)$ corresponds to the phase value of the vector Z(t).

6. A demodulator according to claim 4, wherein the signal modulated in amplitude is preceded by a reference signal at the frequency F and of a given amplitude, these signals having been attenuated by a coefficient $\alpha$, characterized in that the second computer means (C) comprise: a third computer block ($C_2$) constituted by a first memory (42) storing in module value of the vector associated to the reference signal, a first computer device (43) calculating the difference between $\mu$ and the theoretical value $\mu_{th}$ of $\mu$, a second memory (21) delivering the attenuation factor $a$ as a function of this difference, and a multiplier circuit (22) for multiplying the module values of the vector associated to the signal to be demodulated by the factor $a$ and for thus furnishing the corrected module values of the vector associated to the signal which is to be demodulated.

7. The application of a PAL/SECAM demodulator according to one of claims 1 to 6 to a colour TV receiver or monitor or to a colour TV system in which a wave modulated by a composite video signal of the PAL or SECAM system is demodulated in order to extract two chrominance signals besides the luminosity signal.